(19) Europäisches Patentamt
European Patent Office
Office européen des brevets

(11) EP 1 256 978 A2

(12) EUROPEAN PATENT APPLICATION

(43) Date of publication:
13.11.2002 Bulletin 2002/46

(51) Int Cl.7: H01L 21/316

(21) Application number: 02253261.8

(22) Date of filing: 09.05.2002

(84) Designated Contracting States:
AT BE CH CY DE DK ES FI FR GB GR IE IT LI LU
MC NL PT SE TR
Designated Extension States:
AL LT LV MK RO SI

(30) Priority: 09.05.2001 US 851809
19.02.2002 US 79078

(71) Applicant: ASM JAPAN K.K.
Tama-shi, Tokyo 206-0025 (JP)

(72) Inventors:
• Matsuki, Nobuo
Tama-shi, Tokyo 206-0025 (JP)
• Umemoto, Seijiro
Tama-shi, Tokyo 206-0025 (JP)
• Hyoudo, Yasuyoshi
Tama-shi, Tokyo 206-0025 (JP)

(74) Representative: Potter, Julian Mark et al
D. Young & Co.,
21 New Fetter Lane
London EC4A 1DA (GB)

(54) Method of forming low dielectric constant insulation film for semiconductor device

(57) A thin film having a low dielectric constant is formed on a semiconductor substrate by plasma reaction using a method including the steps of: (i) introducing a reaction gas into a reaction chamber for plasma CVD processing wherein a semiconductor substrate is placed on a lower stage; and (ii) forming a thin film on the substrate by plasma reaction while reducing or discharging an electric charge from the substrate surface. In the reaction chamber, an upper region for plasma excitation and a lower region for film formation on the substrate are formed. An intermediate electrode is used to divide the interior of the reaction chamber into the upper region and the lower region. The discharge can also be conducted by lowering the temperature of the lower stage to condense moisture molecules on the substrate surface, especially by using a cooling plate disposed between the intermediate electrode and the lower stage.

FIG. 2

EP 1 256 978 A2

**Description**

BACKGROUND OF THE INVENTION

Field of the Invention

The present invention relates to a plasma CVD (Chemical Vapor Deposition) method for forming a thin film, and particularly to a method for forming a low dielectric constant insulation film for a semiconductor device.

Description of the Related Art

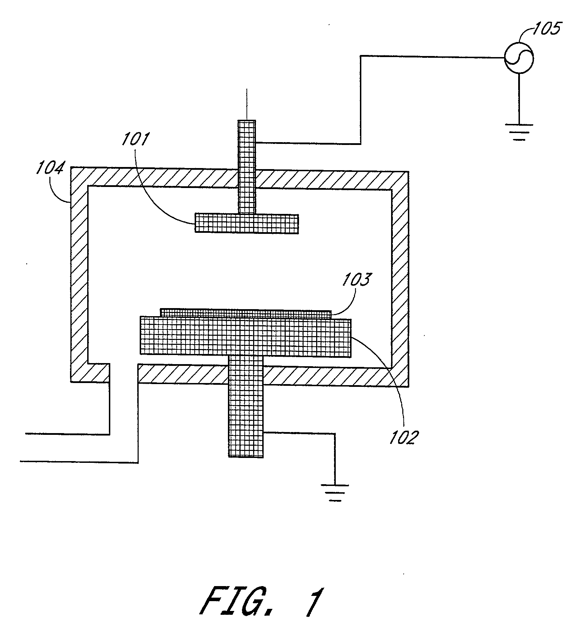

A plasma CVD film-forming method is a technique of forming a thin film on a substrate in a reaction space by generating plasma by bringing microwaves or RF radio-frequency electric power into a reaction chamber. For methods of bringing electric power in, there are the capacity coupling method, the inductive coupling method, the electromagnetic wave coupling method and others. Figure 1 shows an embodiment of plasma CVD equipment of a parallel-flat-plate type using a capacity coupling method. By placing two pairs of electrically conductive flat electrodes 101, 102 parallel to and opposing each other within a reaction chamber 104, applying RF power 105 to one side and grounding the other side, the plasma is excited between these two electrodes to form a film on a substrate 103. Radio-frequency electric power in a megahertz band of 13.56MHz or 27MHz or in a kilohertz band of 400kHz is applied independently or by synthesizing them. In addition to this, there are the ICP method, the ECR method using microwaves, helicon wave plasma, and surface wave plasma, etc. In such film-forming equipment, a method in which a plasma source is placed at the top and a substrate on which a film is formed is placed at a lower stage, and the lower stage is electrically grounded or a bias voltage is applied, is widely used.

For methods of forming a low dielectric constant film using the plasma CVD, a method of forming a film using Teflon CFx with a low dielectric constant as a material, a technique which forms a low dielectric constant film by reducing polarizability by adding fluorine to a Si material and other methods have been reported. In the case of techniques using fluorine, however, because device reliability deteriorates due to the corrosiveness of fluorine and low adhesion of the material, these low dielectric constant films of k < 2.5 have not been put to practical use. When fluorine is not used, to form a low dielectric constant film of k < 2.5, lowering film density by forming a film porously is required. In conventional plasma CVD methods, however, due to electric phenomena such as a sheath occurring near a wafer caused by the wafer being exposed to plasma and a self-bias occurring at a wafer substrate, a film becomes dense and it is difficult to form a low dielectric constant film of k < 2.5 or less.

Regarding coating methods, examples of forming a low dielectric constant film of k < 2.5 or less have been reported including an example of forming a film with a porous structure by controlling sintering conditions and an example of using a supercritical drying method. These methods have not been put to practical use due to many problems, including film quality.

Summary of the Invention

As described above, to integrate semiconductors and to increase the operating speed, in recent years, low dielectric constant films with a dielectric constant of approximately 2.0 are demanded and forming a film with a dielectric constant of approximately 2.0 using a coating method has been reported. However, a film formed by the conventional coating method has problems that it generally has poor film strength and stability and that film formation costs tend to increase. Generally, a thin film formed using a plasma CVD method is of high quality, and thus the method is used in various fields including manufacturing semiconductor devices. Some embodiments of the present invention form a low dielectric constant film with a porous structure comprising Si materials using a CVD.

Viewed from a first aspect, the invention provides a method for forming a thin film on a semiconductor substrate by plasma reaction, comprising of the steps of: (i) introducing a reaction gas into a reaction chamber for plasma CVD processing wherein a semiconductor substrate is placed on a lower stage; and (ii) forming a thin film on the substrate by plasma reaction while reducing or discharging an electric charge from the substrate surface. By reducing or discharging an electric charge from the substrate surface, it is possible to prevent nanoparticles generated by plasma reaction from being repelled from the substrate surface, thereby disposing more nanoparticles on the surface.

In the above, in a particular embodiment, said reducing or discharging is conducted by forming in the reaction chamber a upper region for plasma excitation and a lower region for film formation on the substrate wherein substantially no electric potential. is applied in the lower region to suppress plasma excitation, thereby reducing an electric charge from the lower region. The above can be achieved when the upper region and the lower region are divided by an electrically conductive intermediate plate having plural pores through which the reaction gas passes, wherein substantially no electric potential is applied between the intermediate plate and the lower stage. Further, when plasma excitation is suppressed in the lower region, nanoparticles do not substantially increase in size. Thus, small nanoparticles can disposed on the surface without interference with an electric charge, so that a film having a fine structure with a low dielectric constant can be obtained.

In another embodiment, said reducing or discharging can be conducted by lowering the temperature of the lower stage to condense moisture molecules present in the reaction chamber on the substrate, thereby discharging an electric charge from the substrate surface.

When the intermediate plate and the lower temperature control of the lower stage are used in combination, more nanoparticles having a small diameter can disposed on the surface.

Viewed from another aspect the present invention provides a CVD apparatus for forming a thin film on a semiconductor substrate by plasma reaction. In an embodiment, a CVD apparatus comprises: (a) a reaction chamber; (b) a reaction gas inlet for introducing a reaction gas into the reaction chamber; (c) a lower stage on which a semiconductor substrate is placed in the reaction chamber; (d) an upper electrode for plasma excitation in the reaction chamber; and (e) an electrically conductive intermediate plate with plural pores disposed between the upper electrode and the lower stage, said intermediate plate dividing the interior of the reaction chamber into an upper region and a lower region.

In the above, in a particular embodiment, the intermediate plate and the lower stage are electrically connected to maintain the intermediate plate and the lower stage at the same voltage. Further, in another embodiment, a CDV apparatus further comprises a temperature controller which controls the temperatures of the lower stage, the intermediate plate, and the upper electrode at -10°C-150°C, 50°C-200°C, and 100°C-400°C, respectively.

Viewed from another aspect, the present invention provides a film formed by the above-mentioned methods using a gas containing Si (a Si material gas such as an organosilicon and/or non-organosilicon gas), which film is formed with nanoparticles having a particle size of approximately 50 nm or less (preferably approximately 10 nm or less) and has a low dielectric constant of approximately 2.5 or lower (preferably approximately 2.0 or less). Some embodiments of the present invention enable forming of a low dielectric constant film using a plasma CVD method. Use of this low dielectric constant film as an insulation film for the next-generation highly integrated semiconductor elements can substantially improve the operating speed of the semiconductor elements by decreasing delays caused by capacity between wiring.

The present invention further includes other aspects. The other aspects can specifically resolve problems in conventional structures as explained below.

With a conventional reactor structure, however, because a substrate is exposed to the reaction space, the temperature of and near a substrate surface rises if the temperature of the reaction space and the intensity of plasma are raised. Consequently, the intensity of plasma irradiated on the substrate surface is raised, advancing the reaction of products absorbed and deposited on the substrate surface. It is possible to form products with various molecular weights in a vapor-phase reaction by selecting the type of a reaction gas or adjusting the reactivity of the reaction gas. Particularly to deposit a high vapor pressure product with a relatively low molecular weight on a wafer substrate, it is necessary to lower the temperature of and near the substrate surface. To accelerate the reactivity in the vapor phase, it is necessary to raise the temperature of the reaction space and the intensity of plasma. This, however, raises the temperature of a wafer substrate as well and makes it difficult to deposit high vapor pressure products. When depositing reaction products in an interim phase, a problem occurs wherein the reaction of the product deposited on the substrate advances by plasma irradiation.

To avoid this problem, lowering the temperature of and near the substrate surface and the intensity of plasma irradiated on the substrate by lowering the temperature of the reaction space and the intensity of plasma is considered. By doing this, it becomes possible to deposit a high vapor pressure product and slow down a reaction occurring on the substrate surface become possible. In this case, however, reaction efficiency of the reaction space decreases. Using conventional equipment, the reactivity of the reaction space cannot be increased, the temperature of a substrate cannot be lowered, and a reaction occurring on the substrate surface cannot be suppressed.

In an embodiment of the present invention, provided is a CVD apparatus for forming a thin film on a semiconductor substrate by plasma reaction, comprising: (i) a reaction chamber; (ii) a reaction gas inlet for introducing a reaction gas into the reaction chamber; (iii) a lower stage on which a semiconductor substrate is placed in the reaction chamber, said lower stage functioning as a lower electrode; (iv) an upper electrode for plasma excitation in the reaction chamber; (v) an intermediate electrode with plural pores through which the reaction gas passes, said intermediate electrode being disposed below the upper electrode, wherein a reaction space is formed between the upper electrode and the intermediate electrode; and (vi) a cooling plate with plural pores through which the reaction gas passes, said cooling plate being disposed between the intermediate electrode and the lower stage, said cooling plate being controlled at a temperature lower than the intermediate electrode, wherein a transition space is formed between the intermediate electrode and the cooling plate, and a plasma-free space is formed between the cooling plate and the lower stage.

In another aspect of the present invention, provided is a method for forming a thin film on a semiconductor substrate by plasma reaction, comprising the steps of: (a) introducing a reaction gas into an upper section of a reaction chamber; (b) exciting a plasma in the upper section to react the reaction gas by applying electrical power between an upper electrode and a lower stage on which a substrate is place; (c) enclosing the plasma in the upper section by providing below the upper electrode an intermediate electrode having the same electrical potential as the lower stage, said intermediate electrode having plural pores through which the activated reaction gas passes; (d) cooling a section under the upper section by controlling a cooling plate disposed between the intermediate electrode and the lower stage at a temperature lower than the intermediate electrode, said cooling plate having plural pores through which the cooled reaction gas passes, wherein a middle section is formed between the intermediate electrode and the cooling plate; and (e) controlling the lower stage at a temperature lower than the cooling plate, wherein a lower section is formed between the cooling plate and the lower stage, whereby reaction products accumulate on the substrate.

Some embodiments of the present invention, constructed in accordance with the above aspects, can generally be characterized in that they have a reactor structure, in which a reaction space and a deposition space are separated by an intermediate electrode kept at a high temperature and a low-temperature plate whose temperature is adjusted at a low temperature, and which realizes two completely different environments, a reaction space (a Hot area) which is in a high reactivity state at a high temperature and in a plasma state, and a deposition space (a Cool area) which is at a low temperature and substantially in a non-plasma state.

This reactor enables deposition of a high vapor pressure product with a low molecular weight while realizing high reaction efficiency. In a high-reactivity space (Hot area) where a plasma is excited at a high temperature, by decomposing or polymerizing material gases by thermal and plasma energy, the material gases can effectively react in the vapor phase. By passing a reaction gas through the low-temperature Cool area in which substantially no plasma exists, the reaction can be terminated in the vapor phase and simultaneously gases generated are condensed, and high vapor pressure molecules containing water and alcohol can be liquefied and deposited on a substrate.

For purposes of summarizing the invention and the advantages achieved over the prior art, certain objects and advantages of the invention will be appreciated from or have been described in the above. Of course, it is to be understood that not necessarily all such objects or advantages may be achieved in accordance with any particular embodiment of the invention. Thus, for example, those skilled in the art will recognise that the invention may be embodied or carried out in a manner that achieves or optimizes one advantage or group of advantages as taught herein without necessarily achieving other objects or advantages as may be taught or suggested herein.

Further aspects, features and advantages of this invention will become apparent from the detailed description of the preferred embodiments which follow.

Brief Description of the Drawings

These and other features of this invention will now be described with reference to the drawings of preferred embodiments which are intended to illustrate, by way of example, and not to limit the invention.

Figure 1 is a schematic side view showing a conventional CVD apparatus.

Figure 2 is a schematic side view showing an apparatus according to an embodiment of the present invention.

Figure 3 is a schematic side view showing an intermediate electrode according to an embodiment of the present invention.

Figure 4 is a schematic diagram showing a high intensity X-ray diffuse scattering optical system to measure the size of nano-pores of a film.

Figure 5 is a graph showing the distribution of pore diameters of Example 2.

Figure 6 is a schematic side view showing an apparatus according to an embodiment of the present invention.

Figure 7 is a partial view of a schematic cross-section of an apparatus according to an embodiment of the present invention.

Detailed Description of a Preferred Embodiment

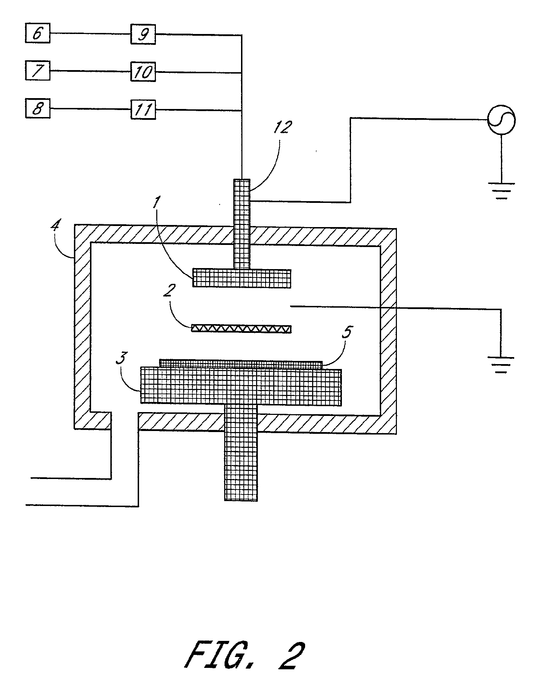

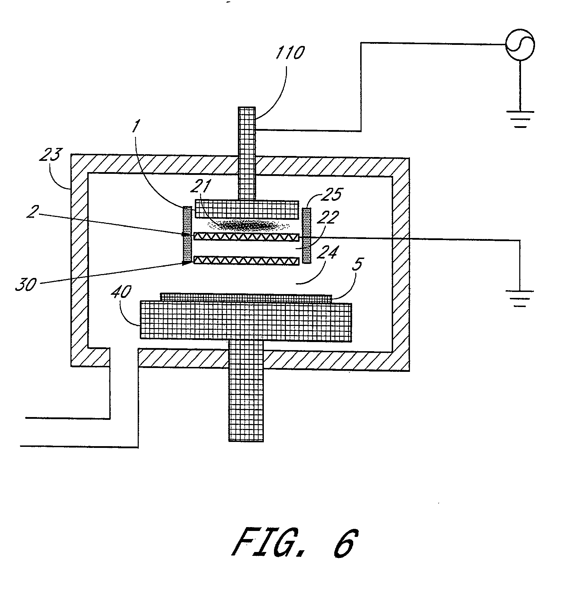

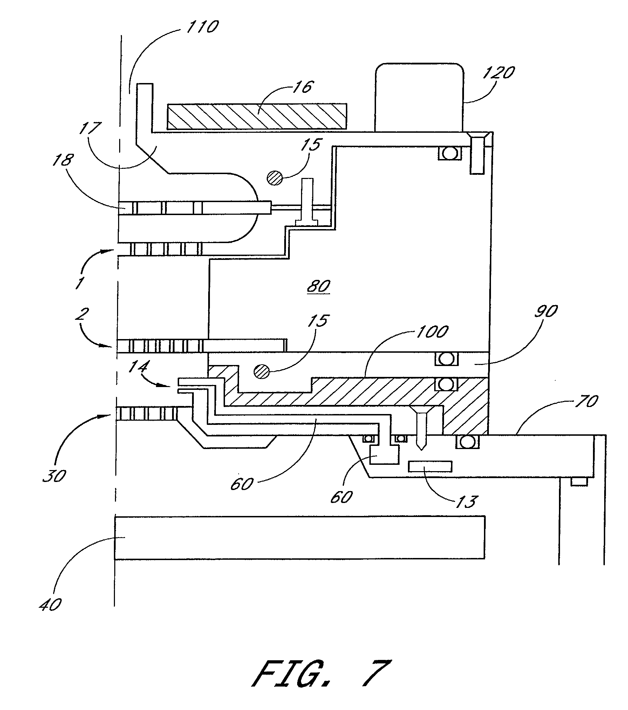

As explained above, the present invention can be accomplished in several ways. The first general configuration is shown in Figure 2, and the second general configuration is shown in Figures 6 and 7.

**First General Configuration**

Figure 2 shows an embodiment of film-forming equipment used in an embodiment of this invention. Two electrically conductive electrodes, an upper electrode 1 and an intermediate electrode 2, and three plates of approximately $\phi$250mm at a lower stage 3 on which a wafer substrate 5 of $\phi$200mm is placed are provided in a vacuum - container 4 which is a reaction chamber. The upper electrode and the intermediate electrode are installed parallel and opposed to each other at an interval of approximately 20mm, and the intermediate electrode and the lower stage are also installed in the same way which is parallel and opposed to each other at an interval of approximately 20mm.

On the upper electrode, the intermediate electrode and the lower stage, an independent temperature regulating mechanism is installed respectively and stated temperatures are maintained. Temperatures are maintained at approximately 100°C-400°C for the upper electrode, approximately 50°C-200°C for the intermediate electrode and approximately -10°C to 150°C for the lower stage.

A material gas (source gas) containing silicon (such as an organic silicon gas expressed by at least $Si\alpha O\beta$-CxHy wherein $\alpha$ is an integer of >0 and $\beta$, x and y are integers of >=0) and added gases such as $N_2O$, He, and Ar are controlled at a stated flow through feeding devices 6-8 and flow regulators 9-11, and after these gases are mixed, they are brought in an inlet 12 at the top of the upper electrode as a reaction gas. On the upper electrode, 500-10,000 pores of $\phi$0.5mm (3,000 pores formed in the mode for carrying out this invention) are formed, and the reaction gas brought in flows through these pores into a reaction space. The reaction space is exhausted by a vacuum pump and a pre-determined fixed pressure is maintained within the limits of 100Pa-5000Pa within which a plasma state can be maintained.

Pulse-modulated radio-frequency electric power of 13.56MHz is applied to the upper electrode, and the intermediate electrode and the lower stage are electrically grounded. Between the upper electrode and the intermediate electrode, the plasma is excited using the capacity coupling method.

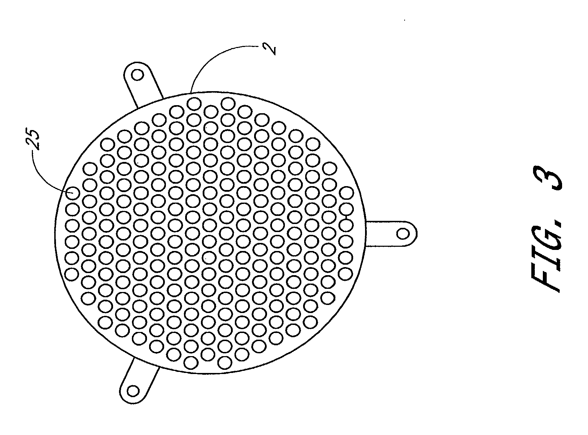

As the intermediate electrode 2, an electrode shown in Figure 3 which is an electrically conductive plate of 5mm in thickness with 500-10,000 (preferably 1,000-5,000) relatively large pores 20 formed (3,000 pores formed in the mode for carrying out this invention) is used. This intermediate electrode is designed so that it separates the upper region which is in a plasma state with a relatively high temperature, from the lower region beneath the intermediate electrode and at the same time a reaction gas flows from the upper region to the lower region.

In an embodiment, the intermediate electrode may have the following profiles:

(a) The material of the intermediate electrode: conductive material such as Al and AlN.
(b) The size of pores: Approximately 0.5-20 mm.
(c) The size of the intermediate electrode: Approximately the size of a showerhead.
(d) The porosity of the intermediate electrode: Approximately 5-100% (preferably 20-100%) (as long as the material functions as an electrode, the configuration can be in the form of a net.)
(e) The position of the intermediate electrode: The distance between the upper electrode and the intermediate electrode: Approximately 5-30 mm; the distance between the intermediate electrode and the lower electrode: Approximately 10-100 mm.
(f) The thickness of the intermediate electrode: Approximately 2-30 mm.
(g) Production of the intermediate electrode: Production method includes, but is not limited to, mechanically processing a material such as an Al-based material, and then subjecting the surface of the processed material to anodization treatment.

**Two Regions Divided by Intermediate Electrode**

In the upper region, plasma is excited between the upper electrode and the intermediate electrode and a material gas causes a polymerization reaction. Since nanoparticles are generated in the upper region, their size is determined by a reaction occurring in the upper region. A reaction gas is brought into a reaction space (the upper region), and until it reaches the intermediate electrode, nanoparticles increase in size. The size of nanoparticles is preferably as small as several nm in diameter, and a required nanoparticle diameter can be obtained by controlling time required for a reaction gas to pass through the upper region and reactivity of the upper region. The time for passing through the upper region, i.e., the time for staying in this region, can be controlled by a total flow of a reaction gas per unit of time. The reactivity of the upper region can be changed mainly by regulating RF power. Alternatively, using pulse-modulated RF power with an 'on time' of approximately 50msec, particle diameter can be controlled by a method of growing nanoparticles by turning the RF power on. As a method of reducing a particle diameter, a minute particle of $\phi$10 nm or less can be generated by reducing the ratio of a Si material gas to be incorporated into a reaction gas.

In the above, in an embodiment, the flow rate of reaction gas in the upper region may be approximately 10-1000 sccm. The RF power exerted in the upper region may be approximately 10 W-1500 W. When pulse-modulated power is applied in the upper region, pulse intervals may be 10-200 msec for activation and 20-100 msec for deactivation. In an embodiment, the size of nanoparticles passing through the intermediate electrode may be approximately 0.5-50 nm.

Nanoparticles generated in the upper space pass through a number of pores formed in the intermediate electrode along with a reaction gas and enter the lower region. Since the electric potential of the intermediate electrode and the lower stage is substantially the same or if they are different, the difference in electric potential is small enough not to excite plasma, the RF power by which plasma is excited does not exist. Ionized particles which enter the lower region become in non-ionized form state after moving in a distance corresponding to the mean free path and colliding with neutral gas molecules. A distance which an ionized particle can move freely, i.e., the mean free path ($\lambda$), can be

obtained by the following formula with P (Pa) as a pressure inside a reaction chamber:

$$\lambda(mm) = 44/p$$

Although, in a high vacuum region of approximately $10^{-4}$ this free path is hundreds of meters which is very long, by increasing the process pressure to 100Pa-1000Pa, however, the mean free path shortens to a very short 0.44mm-0.044mm. Consequently, plasma ions having passed through the intermediate electrode collide with neutral molecules in a short period of time, preventing the plasma state from spreading into the lower region.

The intermediate electrode divides the reaction chamber into two sections. That is, the lower region of the reaction chamber has no significant presence of plasma, whereas the upper region of the reaction chamber has plasma. If plasma exists significantly in the lower region, all portions exposed to plasma, including a wafer substrate, nanoparticles, and the lower electrode, become negatively charged. Accordingly, nanoparticles are repelled from the surface of the wafer substrate by the force of a static charge, and thus nanoparticles cannot dispose on the surface. By using the intermediate electrode, the intensity of the static charge can be suppressed in the lower region, and disposition of nanoparticles can be enhanced. Further, due to no significant presence of plasma in the lower region, nanoparticles do not significantly increase in size and no new nanoparticles are generated in the region. By disposing small nanoparticles on the surface of the wafer substrate, a film having a fine structure can be formed. If large nanoparticles are disposed on the surface, a film has a coarse structure and when being processed for wiring, a processed surface becomes rough, lowering the quality of a device.

The use of an intermediate electrode can effectively eliminate the above-mentioned static charge phenomena and can suppress the growth of nanoparticles in the lower region. However, even if no plasma is excited in the lower region, static charge phenomena cannot completely be eliminated, resulting in formation of a soft film. The lower stage temperature control described below makes it possible to fully release the electric charge of nanoparticles to the lower stage. When the lower stage temperature control is not conducted, by applying bias voltage to the susceptor, it is possible to enhance the strength of a film.

**Lower Stage Temperature Control**

Static charge phenomena can be eliminated by lowering the temperature of the lower stage independently of or in combination with the use of the intermediate electrode. The mechanism can be explained as follows:

When the intermediate electrode, if used, and the lower stage are kept at relatively low temperatures, moisture condenses in the lower region and adheres to particles formed in the upper region. Moisture is present in the reaction chamber as a result of the reaction between oxygen and hydrogen. That is, when a material gas containing hydrogen as a constituent element in its molecule (such as organosilicon or hydrocarbon) is used or hydrogen is added to an additive gas, the hydrogen and oxygen react to produce $H_2O$ in the reaction gas. The moisture condenses when being cooled in the lower region. The vapor pressure of water at 12°C is 10 Torr (133 Pa). Thus, if the pressure of the reaction chamber is approximately 10 Torr, moisture present in the reaction gas condenses when the temperature is lower than 12°C. The condensed moisture adheres to nanoparticles generated in the upper region and the surface of the water substrate. The amount of moisture condensed can be controlled by lowering the temperature of the lower susceptor, increasing the reaction pressure, decreasing the flow of gas, and/or adding hydrogen to generate more moisture, etc.

When nanoparticles accumulate on a wafer, minute particles the size of several tens of nanometers or less do not adhere to a wafer substrate if affected by static charge. By lowering temperatures of the lower space and the lower stage, moisture and material gas by-product molecules (e.g., alcohol such as $CH_3OH$ and $C_2H_5OH$, ether, and organosilicon, SiOxHy), etc. are caused to adhere to a wafer, and the electric charge charged on a wafer is eliminated, whereby more nanoparticles are accumulated on a wafer.

In an embodiment, an intermediate electrode is used and the lower stage is cooled. This combination is effective to dispose small nanoparticles on a wafer substrate. By maintaining the lower stage and the intermediate electrode at the same electric potential and by keeping the reaction chamber in high pressure, dividing a reaction space by the intermediate electrode becomes effective. Spreading into the lower region plasma excited in the upper region can be prevented and the upper space and the lower space can be maintained at different temperatures, i.e., the upper space at a high temperature and the lower space at a low temperature. In this method, it becomes possible to form nanoparticles by facilitating a vapor-phase polymerization reaction by increasing reactivity in the upper space, and in the lower space to end the reaction and at the same time to condense moisture contained in a reaction gas.

Facilitation of moisture condensation can be realized without the use of an intermediate electrode. If no intermediate electrode is used, the lower stage may be cooled to a temperature lower than room temperature while the upper electrode is heated to approximately 150°C or higher. In order to maintain a lower region in the reaction chamber at a low temperature, the distance between the upper electrode and the lower stage needs to be more than approximately 40mm.

**Subsequent Treatment**

The thin film formation process takes 1-20 minutes. After a film is formed, a wafer is transported to another vacuum container and is thermally treated. A film-formed wafer is transported to a vacuum container in a nitrogen atmosphere and is thermally treated for 10 seconds to 5 minutes at a temperature of approximately 200-450°C at reduced pressure (approximately 10-500 Pa). During this treatment, HMDS (Hexamethyldisilano: $Si_2(CH_3)_5$) is brought into this container, and hydrophobicity treatment is performed to suppress the hygroscopicity of a film.

**Effects of First Configuration of the Invention**

Using the above-mentioned method, it becomes possible in an embodiment to cause a plasma reaction in a reaction gas in a state where a wafer substrate is not exposed to plasma, and furthermore, in the same embodiment or in another embodiment, to accumulate a product on a wafer substrate in a space where there is substantially no plasma. Consequently, no significant electric phenomena (such as a sheath occurring near a wafer caused by a wafer being exposed to plasma and a self-bias at a wafer substrate) can occur, and it becomes possible to eliminate plasma damage. In the present invention, a film having a dielectric constant as low as 1.2-2.5 can be produced.

This invention enables forming of a low dielectric constant film using a plasma CVD method. Use of this low dielectric constant film as an insulation film for the next-generation highly integrated semiconductor elements can substantially improve the working speed of the semiconductor elements by decreasing delays caused by capacity between wiring.

**Analysis of Film**

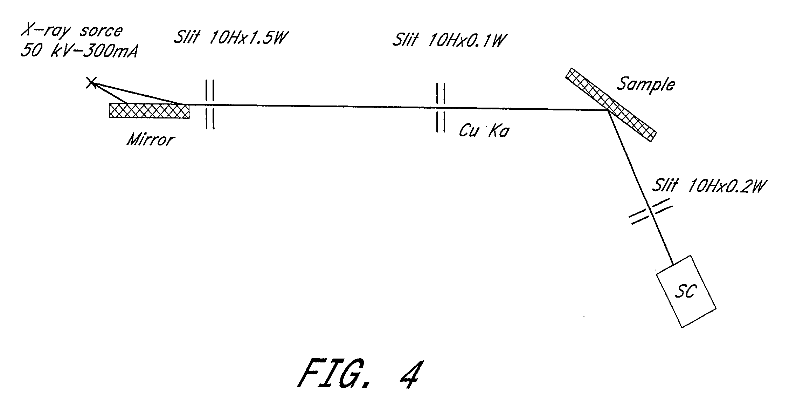

In an embodiment of the present invention, nanoparticles deposit effectively on a substrate, thereby forming a porous film having nano-pores (with a diameter of 50 nm or less, preferably 10 nm or less, or with a median diameter of 10 nm, preferably 1 nm). The size of the nano-pores is similar to that of the nanoparticles. The size of the nano-pores can be measured by a high intensity X-ray diffuse scattering optical system (e.g., ATX-E™, Rigaku Denki X-Ray Laboratory in Japan). Figure 4 shows a schematic diagram of this system. The angle of divergence and the intensity of incoming X-ray are 0.045 and $10^9$ cps, for example. X-ray diffuse scattering data are evaluated by comparing measured data with the theoretical intensity of scattering. Practically, the average diameter and the distributions of scattering objects can be determined by calculating the intensity of X-ray diffuse scattering based on a scattering function in for spherical scattering objects having various diameters.

**Comparison with Other Techniques**

In the case of ion implantation equipment, there is an example which uses an intermediate electrode as a grid electrode in a space between a plasma source and a wafer. The object of the ion implantation equipment is to irradiate ions such as ionized phosphorus, boron, etc. on a Si substrate to implant (dope) these ions on a substrate surface. Consequently, to enable ions to reach a wafer placed on a stage without colliding with other molecules, it is designed that the pressure in a reaction chamber is maintained at a high vacuum of $10^{-4}$ Pa or less, the mean free path of molecules is long to make the number of molecular collisions sufficiently small. Additionally, by applying a voltage difference between an intermediate electrode and a wafer stage, ions passing through the intermediate electrode are selected.

In the ion implantation equipment, since the collision of atoms and molecules in a reaction space is suppressed, a polymerization reaction in a vapor phase does not occur. Additionally, because ions at their high-energy state reach a wafer, these ions are not accumulated on the wafer and are doped inside the wafer. In this invention, by increasing the atmospheric pressure in a reaction space to facilitate a polymerization reaction in a vapor phase, minute particles are generated in a vapor phase. Additionally, these minute particles deposit on a wafer without penetrating inside a wafer substrate.

**Second General Configuration and Effects**

According to the second aspect of the present invention using the Hot area and the Cool area, reaction gases, in which an organic silicon gas containing ethoxy and/or methoxy (such as $Si-O-C_2H_5$, $Si-O-CH_3$ and $Si-CH_8$) and an oxidizing agent (such as oxygen) are mixed, can react even in a non-plasma state if the temperature is raised to nearly 500°C, and the reaction proceeds, forming a solid product (such as SiO). In an environment at a temperature around 400°C or lower, although a reaction does not proceed only by heat, by combining plasma effects, a reaction according to the intensity of plasma can be realized and different products can be formed. By intensifying a plasma, a solid product mainly containing SiO can be formed. By lowering the intensity of plasma, a reaction chemical intermediate with a low molecular weight, which contains Si-OH and Si-CH$_3$ groups, can be formed.

By adjusting RF power applied, the intensity of plasma can be adjusted. By repeating alternating application of high power and low power, an end reaction product and a reaction chemical intermediate with a low molecular weight are repeatedly formed in the reaction space. When a gas containing solids generated is brought in the Cool area, the reaction is terminated. Additionally, because the temperature of the gas rises, gas constituents with a low molecular weight, e.g., moisture and alcohol, condense and it becomes possible to deposit a liquid in sol form on a substrate together with solid products.

FIG. 6 is a schematic side view showing an apparatus according to an embodiment of the present invention. Two conductive electrodes comprising an upper electrode 1 of, e.g., approximately Φ100mm (preferably smaller in diameter than a substrate, more preferably 20-75% of the substrate diameter, further preferably 50±10% of the substrate diameter) and an intermediate electrode 2 (having approximately the same diameter as that of the upper electrode 1), a low-temperature plate 30 kept at a low temperature (having approximately the same diameter as that of the upper electrode 1), and a lower stage 40 of approximately Φ250mm (preferably greater in diameter than the substrate, more preferably 10-50% greater than the substrate) on which a wafer substrate 5 of, e.g., Φ200mm (preferably 100-350mm in diameter) is placed, are installed in a vacuum container 23 which is a reaction chamber. In the above, the diameter of the upper electrode, the intermediate electrode, or the low-temperature plate is the actual physical diameter, and the effective diameter (which can be used for chemical reactions) may be 50-100% of the actual physical diameter.

The upper electrode 1 and the intermediate electrode 2 are installed at an interval of, e.g., approximate 20mm (preferably 10-30mm). The reaction of source gases introduced through an inlet port 11 takes place in a space 21 defined between the upper electrode 1 and the intermediate electrode 2, which space is referred to as a "reaction space" or "hot space". If the distance between the upper electrode 1 and the intermediate electrode 2 is small, the reaction does not progress sufficiently, although the progress of the reaction also depends on the residence time of the source gases in the space. On the other hand, if the distance is large, the reaction efficiency increases significantly, resulting in that no or a little interim reaction occurs and no or a little chemical intermediate is produced.

The intermediate electrode 2 and the low-temperature plate 30 are installed at an interval of, e.g., approximately 10mm (preferably 5-30mm including 20mm). A space 22 defined between the intermediate electrode 2 and the low-temperature plate 30 is referred to as a "transition space" The low-temperature plate 2 is kept at a lower temperature than the intermediate electrode 2, and thus the distance therebetween cannot be very close, although the closer the better. The low-temperature plate 30 is for reducing the temperature immediately downstream of the intermediate electrode 2, so that interim reactions can occur, causing chemical intermediates to accumulate on the substrate 5. One or more additional low-temperature plates can be installed to further reduce the temperature. Additionally, in an embodiment, one or more intermediate electrodes can be installed, wherein the additional intermediate electrodes are controlled at lower temperatures than the first intermediate electrode. The transition space may be slightly larger in diameter than the reaction space (e.g., 5-20%), if they are different.

The low-temperature plate 30 and the lower stage 40 are installed e.g., approximately 40mm apart (preferably 20-150mm, more preferably 50-100mm), running parallel and facing each other. The distance between the low-temperature plate 30 and the lower stage 40 is for promoting deposition of chemical intermediates. A space 24 defined between the low-temperature plate 4 and the lower stage 40 is referred to as a "plasma-free space", "cool space", or "lower region". In view of the chemical reactions, a long distance is preferred, whereas in view of the machine design, a short distance is preferred.

In the above, if the diameter of the reaction space 21 is relatively large, the distance between the intermediate electrode 2 and the substrate 5 needs to be widened. This is because the larger the size of the reaction space, the more the reaction gas is supplied, and then the more the cool space is required.

The reaction space 21 located between the upper electrode 1 and the intermediate electrode 2 is preferably a cylindrical space with an internal diameter of e.g., Φ60mm (preferably 40-100mm in diameter or 50-100% of the actual physical diameter of the upper electrode 1) enclosed by an insulator 25. The transition space 22, which is enclosed by the intermediate electrode 2 and the low-temperature plate 30, is also isolated at its periphery by the insulator 25. The insulator 25 is in contact with the upper electrode 1, the intermediate electrode 2, and the low-temperature plate 4 (a gap shown in Figure 6 simply indicates that the above elements are separate elements).

Reaction gases brought in the reaction space are regulated at a given flow rate by a feeder and a flow regulator. These gases are mixed together and are brought into the inlet port 11 installed on the upper electrode as a reaction gas. The reaction gas flows into the reaction space 21 through pores provided in the upper electrode 1. Independent thermostats may be attached to the upper electrode 1, the intermediate electrode 2, the low-temperature plate 30, and the lower stage 40, respectively. The temperature of the upper electrode 1 and that of the intermediate electrode 2 may be the same, whereas the temperature of the low-temperature plate 30 may be lower than the former, and the temperature of the lower stage 40 may be lower than that. The upper electrode 1 may be kept at approximately 150°C to 350°C (in some cases, 100-400°C; in other cases, 200-300°C). The intermediate electrode 2 may be kept at a given temperature of approximately 150°C to 350°C (in some cases, 100-400°C; in other cases, 200-300°C). A suitable temperature range may be selected depending on the type of chemical reaction and the RF power level. If the upper electrode 1 is set at a temperature higher than a thermal reaction temperature of the reaction gas, products adhere to the inside of the upper electrode 1 (on the inlet port 11 side). For this reason, the temperature of the upper electrode 1 preferably be adjusted at a temperature lower than the thermal reaction temperature of the reaction gas. The temperature of the intermediate electrode may be lower than that of the upper electrode. Further, one or more additional intermediate electrodes can be installed with temperature control.

When organic Si gas containing Si-O-CH$_3$ groups, for example, is used as a material gas, or when oxidizing gases such as oxygen and H$_2$O, for example, are added as reaction gases, it may be effective to control the temperature at approximately 250°C to 300°C.

The low-temperature plate 30 may be kept at 0°C to 100°C and the lower stage 40 may be kept at approximately -10°C to 50°C. In some cases, the low-temperature plate 30 may be kept at a temperature 100-300°C lower than the temperature of the upper electrode 1 or the intermediate electrode 2, and the lower stage 40 may be kept at a temperature 30°C to 80°C lower than the temperature of the low-temperature plate 30.

FIG. 7 is a view showing a cross-section of deposition equipment (the right half portion) usable in an embodiment of the present invention. Two conductive electrodes comprising an upper electrode 1 (e.g., Φ100mm in diameter) and an intermediate electrode 2, a low-temperature plate 30 kept at a low temperature, and a lower stage 40 on which a wafer substrate (e.g., Φ200mm in diameter) is placed, are installed in a vacuum container which is a reaction chamber. The distance between the upper electrode 1 and the intermediate electrode 2, between the intermediate electrode 2 and the low-temperature plate 30, and between the low-temperature plate 30 and the lower stage 40 are 20mm, 10mm, and 40mm, respectively, for example.

In this embodiment, for the upper electrode 1, a conductive plate of 10mm in thickness with 100 to 8,000 pores of approximately Φ0.5mm (1,000 pores for the embodiment described later) is used. For the intermediate electrode 2, a conductive plate of 5mm in thickness with 100 to 3,000 relatively large pores of approximately Φ2mm (200 pores for the embodiment described later) is used.

In the cooling plate as well, there are 100 to 3,000 pores of approximately Φ2mm. The low-temperature plate 30 is installed on a cooling block 70 together with a cooling gas inlet block 60. A cooling gas piping 14 leads to the transition space to provide a structure in which a gas can be brought in between the intermediate electrode 2 and the low-temperature plate 30 (cooling plate). A cooling water path 13 is provided in the cooling block 70. Cooling gas passes through a gas inlet path provided inside the cooling plate and flows inside the cooling gas piping, then into the cool space from the pores provided in the cooling plate 30. The cooling gas may be a non-reactive gas such as He, N$_2$, and Ar.

The reaction space located between the upper electrode 1 and the intermediate electrode 2 is a cylindrical space with an internal diameter of Φ60mm enclosed by an insulator 80. The intermediate electrode 2 is fixed at a temperature control block 90 with a heater 15 and kept at a given temperature. Between the low-temperature plate 30 and the temperature control block 90, a heat-insulating plate 100 made of a material with low thermal conductivity such as ceramics is placed. The transition space, which is enclosed by the intermediate electrode 2 and the low-temperature plate 30, is isolated at its periphery by the heat-insulating plate 100.

Reaction gases brought in the reaction space are regulated at a given flow rate by a feeder and a flow regulator. These gases are mixed together and are brought into an inlet port 110 installed on the upper electrode as a reaction gas. The reaction gas flows into the reaction space through the pores provided in the upper electrode 1. Independent thermostats are attached to the upper electrode 1, the intermediate electrode 2, the low-temperature plate 30, and the lower stage 40, respectively.

Regulated at a given flow rate by a flow regulator, the cooling gas flows into the cool space through the pores provided in the cooling plate 30.

The air inside a lower space (or the cool space) is exhausted by a vacuum pump and is kept at the given pressure of 100Pa to 10000Pa. 27MHz radio-frequency power is applied to the upper electrode 1. The intermediate electrode 2, the cooling plate 30, and the lower stage 40 are electrically grounded. A plasma is excited between the upper electrode 1 and the intermediate electrode 2 by the capacity coupling method. As for the power applied, a high reactivity state and a low reactivity state are repeated continuously by repeating application of high power and low power at an interval of approximately 10msec to 1sec.

In the above, in an embodiment, the flow rate of a source gas in the reaction space may be approximately 10-1000 sccm. The RF power exerted in the reaction space may be approximately 10 W-1500 W. When alternating high power application and low power application, the high power may be 500-1500 W whereas the low power may be 200-400 W. In an embodiment, the size of nanoparticles passing through the intermediate electrode may be approximately 0.5-50 nm.

Additionally, in Figure 7, a cooling fin 120 is attached to an upper body 17. An insulator 16 is placed on the upper body 17. A distribution plate 18 is attached to the upper body 17 and installed above the upper electrode 1 to efficiently heat the source gas upstream of the upper electrode 1.

**Intermediate Electrode and Cooling Plate**

As the intermediate electrode 2, an electrode which is an electrically conductive plate of 2-30 mm (e.g., 5 mm) in thickness with 500-10,000 (e.g., 1,000-5,000) relatively large pores formed can be used. This intermediate electrode is designed so that it separates an upper region (reaction space) which is in a plasma state with a relatively high temperature, from a lower region (transition space) beneath the intermediate electrode and at the same time a reaction gas flows from the upper region to the lower region.

In an embodiment, the intermediate electrode may have the same profiles as in the first general configuration.

The cooling plate can have the same configurations as the intermediate electrode with regard to the pores. Alternatively, the cooling plate may have different configurations from the intermediate electrode in the ranges described above for the intermediate electrode. One or more additional cooling plates can be installed in order to cool the source gas more efficiently. The cooling plate may be made of aluminum, for example.

**Deposition Reaction**

A material gas (source gas) containing silicon (such as an organic silicon gas expressed by at least $Si\alpha O\beta$-CxHy wherein $\alpha$ is an integer of $>0$ and $\beta$, x and y are integers of $>=0$) and added gases such as $N_2O$, He and Ar are controlled at a stated flow through feeding devices 6-8 and flow regulators 9-11, and after these gases are mixed, they are brought in an inlet 110 at the top of the upper electrode as a reaction gas. On the upper electrode, 500-10,000 pores of $\phi0.5mm$ (3,000 pores formed in the mode for carrying out this invention) are formed, and the reaction gas brought in flows through these pores into a reaction space. The reaction space is exhausted by a vacuum pump and a pre-determined fixed pressure is maintained within the limits of 100Pa-5000Pa within which a plasma state can be maintained.

All gases involved in the reaction including material gases and added gases such as oxygen are brought in the upper zone enclosed by the upper electrode and the intermediate electrode, which is kept at a high temperature, and a plasma is excited between the electrodes to make material gases react. In the upper zone which is a reaction space, nanoparticles are generated. The diameter of a nanoparticle is determined by the reaction conditions in the upper zone. The reaction gases are brought in the reaction space (upper zone) and nanoparticles grow while passing through the intermediate electrode. The diameter of the nanoparticle can be adjusted mainly by the time required for the reaction gas molecules to react in the reaction space. The reaction time is the time elapsed for the reaction space (the reaction gas molecules) to pass through the upper zone. In other words, the reaction time can be adjusted by changing the length of time the reaction gas molecules remain in the zone. Additionally, the diameter of the nanoparticle can be adjusted by exposure time when the high-frequency power is turned on. By applying high-frequency RF power for approximately 50msec, the diameter grows to approximately several nanometers. After that, by turning off the power applied, a plasma ceases to exist in the order of $\mu$sec and a polymerization reaction is terminated. In this method, nanoparticles with a small particle diameter can be obtained by stopping the growth of the particle diameter. By reducing the reactivity of the reaction space by lowering the power applied, it is possible to generate a product in an interim phase. By repeating a step in which high power is applied and a step in which low power is applied, nanoparticles and intermediate reaction products can be generated continuously.

Nanoparticles generated in the upper space behave similarly to those in the first general configuration.

Additionally, because the low-temperature plate and the lower stage are kept at a low temperature, molecules with a relatively low molecular weight also condense in the lower zone and are deposited on the wafer substrate together with solid products such as particles. Minute particles of tens nanometers or less do not adhere to the wafer substrate if influenced by static electricity. A gas with a low molecular weight, which is contained in a reaction gas, condenses by lowering the temperature, and liquefies. This liquid adheres to nanoparticles, and the nanoparticles can be transferred to the substrate together with the liquid. When a reaction gas sufficiently contains hydrogen and oxygen atoms, water molecules are generated in the reaction space and moisture adheres to the wafer substrate. Because of this moisture, a charging phenomenon of a wafer substrate is suppressed and deposition of nanoparticles on the wafer is accelerated.

By changing the RF power intensity, progress of the chemical reaction can be controlled, and chemical intermediates can be generated and accumulate on the substrate, in addition to final reaction products. For example, final reaction products are produced as follows:

$$(CH_3)_2Si(OCH_3)_2 + 7O_2 \rightarrow SiO_2 + 6H_2O + 4CO_2$$

Chemical intermediates may be produced as follows:

$$(CH_3)_2Si(OCH_3)_2 + O_2 + H_2 \rightarrow Si(CH_3)_2\,OH + 2CH_3OH$$

Depending on the source gas, final reaction products and chemical intermediates will vary in accordance with similar reaction schemes to the above.

Chemical intermediates accumulate with moisture generated by the reactions on a surface of a substrate, wherein the chemical intermediates are in a liquid or sol state on the surface. When the substrate is heated, the liquid or sol state chemical intermediates are solidified. The moisture coexisting with the chemical intermediates neutralizes static electricity, thereby promoting deposition of nanoparticles which are included in the solidified layer. On the other hand, final reaction products are in a solid state and accumulate on the surface of the substrate. By mixing or layering the chemical intermediates and the final reaction products on the surface of the substrate, upon subsequent heating treatment of the substrate, the substrate having a hybrid film formed thereon is obtained. The hybrid film has a porous structure with excellent mechanical strength. By alternately forming a layer of chemical intermediates and a layer of final reaction products, the resulting hybrid film can be uniform in depth and be excellent in mechanical strength.

The subsequent treatment can be accomplished similarly to that in the first general configuration.

**Comparison with Configuration using No Cooling Plate**

In an embodiment of the present invention, a cooling plate is used in addition to an intermediate electrode. It is possible to separate an upper region and a lower region using only an intermediate electrode without a cooling plate as described in the first general configuration. However, the use of a cooling plate is advantageous as explained below.

Comparing an embodiment of the present invention with an apparatus using no cooling plate can be summarized below (this is simply an example and does not limit the present invention).

|  | Second Configuration | First Configuration |
| --- | --- | --- |
| Hardware Configuration | An intermediate electrode and a cooling plate | An intermediate electrode only |
| Reaction Space Size | Diameter: smaller than a wafer substrate (e.g., 1/2) | Diameter larger than a wafer substrate |
| Total Flow of Reaction Gas | Process using a flow of beyond 200sccm (e.g., 1000sccm or more) | A small flow of 100 to 200sccm |

In the technology without using a cooling plate, if the total flow of a reaction gas is increased, the reaction gas cannot be sufficiently cooled down in the deposition space. As a result, the temperature of a substrate surface rises and products with a low molecular weight cannot be sufficiently liquefied. Because of this, a total flow of the reaction gas cannot be increased beyond 200sccm, causing poor gas diffusion effects and making deposition on the whole surface impossible. In an embodiment of the present invention, by using a cooling plate and reducing the size of a reaction space, even with a large flow of approximately 3,000sccm, the reaction gas is sufficiently cooled down in the deposition space, and solid particles and liquid products are deposited on the entire substrate surface efficiently. Additionally, because deposition is possible under conditions with a large flow, a film can be formed evenly on the entire substrate surface.

**Comparison with Other Techniques**

Under discussion is a technology in which a remote plasma unit is attached outside a reactor, an added gas such as Ar and oxygen is brought in the remote plasma unit, a plasma is excited by high-frequency power to activate the added gas, the activated added gas and a main material gas brought in from a different system are mixed inside the reactor or immediately before being brought into the reactor, and a film is formed inside the reactor. In this case as well, because the main material gas is made to react inside the reactor in which a wafer substrate is placed, it is impossible to separate a space used for a reaction and a space used for a reaction completion/deposition.

**Experimental Results: First Configuration**

Example 1

20sccm of TEOS as a material gas, and 80sccm of $O_2$, 50sccm of Ar, and 50sccm of He as additive gases were introduced through feeding devices 6, 7, and 8 and flow regulators 9, 10, and 11 and mixed, and the mixed gas was brought into a reaction chamber 4 as a reaction gas through an inlet 12 (see Figure 2). The pressure within the reaction chamber 4 was maintained at $2 \times 10^3$Pa by constantly exhausting the gas with a vacuum pump. 300W 13.56MHz RF power was applied to an upper electrode 1. A temperature of the upper electrode 1, an intermediate electrode 2 and a lower stage 3 was adjusted at a fixed temperature of 170°C, 50°C and 0°C respectively. A wafer substrate 5 set in the lower stage 3 was inserted into a vacuum container for thermal treatment after a film was formed, and drying in a $N_2$ atmosphere and hydrophobicity treatment by HMDS were performed. The measured dielectric constant of a film formed under these conditions was 2.05.

Example 2

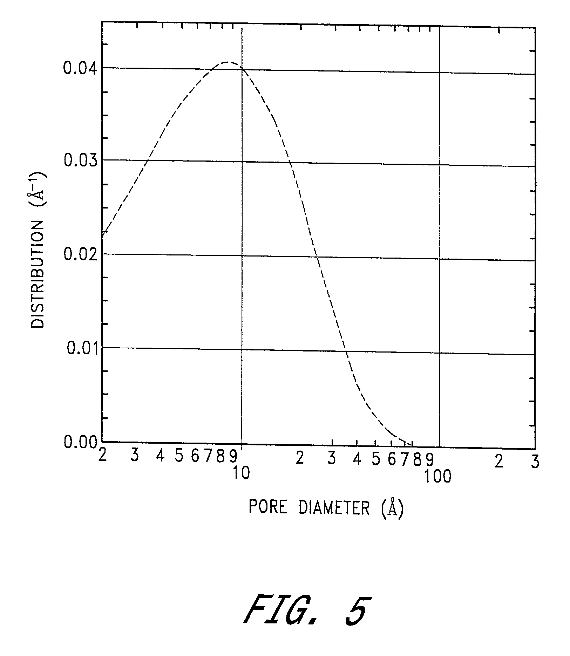

20sccm of Dimethyldimetoxysilane (DM-DMOS) : $(CH_3)_2Si(OCH_3)_2$ as a material gas, and 100sccm of $O_2$, 50sccm of Ar, and 50sccm of He as additive gases were introduced via feeding devices 6, 7, and 8, and flow regulators 9, 10, and 11, and mixed, and the mixed gas was brought into a reaction chamber 4 as a reaction gas through an inlet 12. The pressure within the reaction chamber 4 was maintained at $2 \times 10^3$Pa by constantly exhausting the gas by a vacuum pump. 800W 13.56MHz RF power was applied to an upper electrode 1. A temperature of the upper electrode 1, an intermediate electrode 2 and a lower stage 3 was adjusted at a fixed temperature of 170°C, 50°C and 0°C, respectively. A wafer substrate 5 set in the lower stage 3 was inserted in a vacuum container for thermal treatment after a film was formed, and drying in a $N_2$ atmosphere and hydrophobicity treatment by HMDS were performed. The measured dielectric constant of a film formed under these conditions was 1.90, and the film had nano-pores having a diameter of approximately 10 nm or less and the median diameter was approximately 1 nm, which represented the size of nanoparticles (Figure 5, obtained by a high intensity X-ray diffuse scattering optical system, ATX-E™, Rigaku Denki X-Ray Laboratory in Japan).

Example 3

20sccm of Dimethyldimetoxysilane (DM-DMOS) : $(CH_3)_2Si(OCH_3)_2$ as a material gas, 100sccm of $O_2$, 50sccm of Ar, and 50sccm of He as additive gases were introduced via feeding devices 6, 7, and 8, and flow regulators 9, 10, and 11, and mixed, and the mixed gas was brought into a reaction chamber 4 as a reaction gas. The pressure within the reaction chamber 4 was maintained at $2 \times 10^3$Pa by constantly exhausting the gas by a vacuum pump. Pulse-modulated 400W 13.56MHz RF power was applied to an upper electrode 1. A temperature of the upper electrode 1, an intermediate electrode 2 and a lower stage 3 was adjusted at a fixed temperature of 170°C, 50°C and 0°C, respectively. A wafer substrate 5 set in the lower stage 3 was inserted in a vacuum container for thermal treatment after a film was formed, and drying in a $N_2$ atmosphere and hydrophobicity treatment by HMDS were performed. The measured dielectric constant of a film formed under these conditions was 1.90.

Comparative Example

An experiment of forming a low dielectric constant film using a plasma CVD method of a parallel-flat-plate type was conducted. Figure 1 shows an embodiment of plasma CVD equipment used for a film-forming experiment. With an electrically conductive circular plate of $\phi$250mm used as a lower stage 102 and electrically conductive circular plate of $\phi$250mm having a limitless number of pores used as an upper electrode 101, these plates were installed parallel to and opposing each other at an interval of 24mm within a reaction chamber. A temperature of the lower stage 102 was kept at 400°C at all times. The gas within a reaction chamber 104 was constantly exhausted using a vacuum pump and the pressure was maintained at a stated pressure.

The wafer of a substrate 103 on which a film is formed was set in the lower stage 102, 120sccm of Dimethyldimetoxysilane (DM-DMOS) : $(CH_3)_2Si(OCH_3)_2$ and He:100sccm were mixed, and the mixed gas was brought into the reaction chamber 104 as a reaction gas through the pores of the upper electrode 101. A pressure within the reaction chamber 104 was maintained at $6.7 \times 10^2$Pa, the lower stage 102 was electrically grounded and 1200W 13.56MHz RF power was applied to the upper electrode 101 to form a film on the wafer substrate 103. The measured dielectric constant of a film formed under these conditions was 2.76.

**Experimental Results: Second Configuration**

<u>Example 4</u>

100sccm of Dimethyldimetoxysilane(DM-DMOS):$(CH_3)_2Si(OCH_3)_2$ as a material gas, and $O_2$: 70sccm, $H_2$: 100sccm, and Ar:3000sccm as added gases were introduced mixed and brought in a reaction chamber 23 as a reaction gas through an inlet 110 (see Figure 6). The pressure inside the reaction chamber 23 was maintained at 1.3 x $10^3$Pa at all times by exhausting the air by a vacuum pump. 27MHz RF power was applied to the upper electrode 1 repeatedly by alternating high power (1200W) with which nanoparticles were formed in a high-power step, and low power (300W) with which products with a relatively low molecular weight were formed in a low-power step. The upper electrode 1 was kept at a given temperature of 200°C, the intermediate electrode 2 was kept at a given temperature of 200°C, and the cooling plate 30 and the lower stage 40 were kept at 70°C and at 0°C respectively. After deposition, a wafer substrate 5 placed on the lower stage 40 was inserted into a vacuums container used for thermal treatment. Drying in the $N_2$ atmosphere and hydrophobing by HMDS were conducted, and a film was formed on the whole substrate surface. A dielectric constant measured by applying 1MHz voltage to the film formed under these conditions was 2,0 and the diameter of a nanoparicle comprising the film was approximately 10nm or less and the median diameter was approximately 1 nm, which represented the size of nanoparticles.

The above result was compared with the result in Example 3. In Example 3, a film was formed only in an area of approximately $\phi$50mm from the center of the wafer, and no film was formed in a periphery area outside the inner area on the wafer.

**Industrial Applicability**

With an embodiment of the present invention, using plasma CVD, deposition of a low-dielectric-constant film with a dielectric constant of 2.5 or less becomes possible. Using this low-dielectric-constant film as an insulation film for next-generation highly integrated microchips, delay caused by wiring capacity can be lowered and the working speed of a microchip can be substantially increased.

**Various Embodiments of the Present Invention (Especially the Second Configuration)**

As explained above, some embodiments of the present invention can be adopted to a plasma CVD apparatus. The present invention can include the following various embodiments, wherein each embodiment can be employed singly or in combination with two or more:

1) A plasma CVD deposition apparatus which comprises at least one conductive plate (intermediate electrode) with multiple holes between an upper space in which a plasma is generated and a lower space in which a substrate, on which a film is formed, is placed; further, which is characterized in that the apparatus comprises a structure for having a plasma source over the intermediate electrode, exciting a plasma in the upper space of the intermediate electrode, making source gases react, placing a substrate in a space lower than the intermediate electrode, and depositing products on the substrate, and further characterized in that the lower space is divided into a transition space and a plasma-free space by a cooling plate with multiple holes having a temperature lower than that of the intermediate electrode.

2) The apparatus may have more than one transition spaces formed by more than one cooling plates.

3) The reaction space may be smaller in diameter than the substrate.

4) The apparatus may comprise a structure for bringing all gases such as material gases and additive gases contributing to a reaction into the reaction space in which a plasma is excited.

5) The apparatus may have an upper electrode provided over the intermediate electrode, and 13.56MHz or 27MHz RF radio-frequency power may be applied to the upper electrode for exciting a plasma in the reaction space between the upper electrode and the intermediate electrode.

6) The upper electrode may include a heating mechanism.

7) The upper electrode may be controlled at a temperature of 150°C or higher.

8) The upper electrode may be controlled at a temperature of 200°C or higher.

9) The intermediate electrode may be controlled at a temperature of 100°C or higher.

10) The cooling plate (low-temperature plate) may be controlled at a temperature of 100°C or lower.

11) The apparatus may have a structure in which a cooling gas can be brought into the transition space between the intermediate electrode and the low-temperature plate.

12) The intermediate electrode and a lower stage on which the substrate is placed are electrically connected to provide the same electrical potential (no difference in electrical potential).

13) The apparatus may comprise a power source which operates to repeat a first step of applying power for a pre-set period of time of 1msec or longer, and a second step of applying power higher than that applied in the first step for a pre-set period of time of 1msec or longer.

14) The apparatus may comprise a power source which operates a step of intermittently applying power for a pre-set period of time of 1msec or longer.

15) The power may be pulse radio-frequency power applied at an interval of 1msec or shorter.

16) The apparatus may form a film containing nanoparticles with diameter of 50nm or less using a reaction gas containing at least Si, C, H and O elements.

17) The lower stage may be controlled at a temperature of 100°C or lower.

18) The apparatus may form a low-dielectric-constant film with a dielectric constant of 2.5 or less upon performing thermal treatment.

19) A non-reactivity gas can be brought into the transition space.

It will be understood by those of skill in the art that numerous and various modifications can be made without departing from the spirit of the present invention. Therefore, it should be clearly understood that the forms of the present invention are illustrative only and are not intended to limit the scope of the present invention.

Further, the scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during the prosecution of this application or of any such further application derived therefrom. In particular, with reference to the appended claims, features from dependent claims may be combined with those of the independent claims and features from respective independent claims may be combined in any appropriate manner and not merely in the specific combinations enumerated in the claims.

For the avoidance of doubt, the term "comprising" used in the description and claims should not be construed to mean only "consisting only of".

## Claims

1.  A method for forming a thin film on a semiconductor substrate by plasma reaction, comprising the steps of:

    introducing a reaction gas into a reaction chamber for plasma CVD processing wherein a semiconductor substrate is placed on a lower stage; and
    forming a thin film on the substrate by plasma reaction while reducing or discharging an electric charge from the substrate surface.

2.  The method according to Claim 1, wherein said reducing or discharging is conducted by forming in the reaction chamber a upper region for plasma excitation and a lower region for film formation on the substrate wherein substantially no electric potential is applied in the lower region to suppress plasma excitation, thereby reducing an electric charge from the lower region.

3.  The method according to Claim 1 or Claim 2, wherein the pressure of the reaction chamber is 100-5000 Pa.

4.  The method according to any one of Claims 1 to 3, wherein the upper region and the lower region are divided by an electrically conductive intermediate plate having plural pores through which the reaction gas passes, wherein substantially no electric potential is applied between the intermediate plate and the lower stage.

5.  The method according to Claim 4, wherein the intermediate plate and the lower stage are electrically connected to maintain the intermediate plate and the lower stage at the same voltage.

6.  The method according to any one of Claims 1 to 5, wherein the reaction gas comprises a source gas which is introduced into the upper region of the reaction chamber.

7.  The method according to any one of Claims 4 to 6, wherein an upper electrode is placed above the intermediate plate in the upper region, and plasma is excited between the upper electrode and the intermediate plate.

8.  The method according to Claim 7, wherein pulse-modified power is applied between the upper electrode and the intermediate plate.

9.  The method according to any one of Claims 1 to 8, wherein the reaction gas comprises Si.

10. The method according to any one of Claims 1 to 9 wherein said reducing or discharging is conducted by lowering the temperature of the lower stage to condense moisture molecules present in the reaction chamber on the substrate, thereby discharging an electric charge from the substrate surface.

11. The method according to any one of Claims 1 to 10, wherein plasma is excited between an upper electrode and the lower stage, the temperature of the lower stage being lower than room temperature, the temperature of the upper electrode being 150°C or higher.

12. The method according to Claim 10 or Claim 11, wherein the moisture molecules are produced from oxygen and hydrogen present in the reaction gas.

13. The method according to any one of Claims 1 to 12, wherein said reducing or discharging is further conducted by lowering the temperature of the lower stage to condense moisture molecules present in the reaction chamber on the substrate, thereby discharging an electric charge from the substrate surface.

14. The method according to Claim 13, wherein plasma is excited between an upper electrode and the lower stage, the temperature of the lower stage being in the range of -10°C-150°C, the temperature of the intermediate plate being in the range of 50°C-200°C, the temperature of the upper electrode being 100°C or higher, wherein the temperature of the lower stage is lower than that of the intermediate plate and the upper electrode.

15. A CVD apparatus for forming a thin film on a semiconductor substrate by plasma reaction, comprising:

   a reaction chamber;
   a reaction gas inlet for introducing a reaction gas into the reaction chamber;
   a lower stage on which a semiconductor substrate is placed in the reaction chamber;
   an upper electrode for plasma excitation in the reaction chamber; and
   an electrically conductive intermediate plate with plural pores disposed between the upper electrode and the lower stage, said intermediate plate dividing the interior of the reaction chamber into an upper region and a lower region.

16. The apparatus according to Claim 15, wherein the intermediate plate and the lower stage are electrically connected to maintain the intermediate plate and the lower stage at the same voltage.

17. The apparatus according to Claim 15 or Claim 16, further comprising a temperature controller which controls the temperatures of the lower stage, the intermediate plate, and the upper electrode at -10°C-150°C, 50°C-200°C, and 100°C or higher, respectively.

18. A film formed by a method of any one of Claims 1 to 14 using a silicon-containing gas, which has nano-pores having a median diameter of 10 nm or less and has a low dielectric constant of 2.5 or lower

19. A CVD apparatus for forming a thin film on a semiconductor substrate by plasma reaction, comprising:

   a reaction chamber;
   a reaction gas inlet for introducing a reaction gas into the reaction chamber;
   a lower stage on which a semiconductor substrate is placed in the reaction chamber, said lower stage functioning as a lower electrode;
   an upper electrode for plasma excitation in the reaction chamber;
   an intermediate electrode with plural pores through which the reaction gas passes, said intermediate electrode being disposed below the upper electrode, wherein a reaction space is formed between the upper electrode and the intermediate electrode; and
   a cooling plate with plural pores through which the reaction gas passes, said cooling plate being disposed between the intermediate electrode and the lower stage, said cooling plate being controlled at a temperature lower than the intermediate electrode, wherein a transition space is formed between the intermediate electrode and the cooling plate, and a plasma-free space is formed between the cooling plate and the lower stage.

20. The apparatus according to Claim 19, wherein the reaction space is smaller in diameter than the substrate to be placed on the lower stage.

21. The apparatus according to Claim 19 or Claim 20, further comprising one or more additional cooling plates, wherein one or more additional transition spaces are formed therebetween.

22. The apparatus according to any one of Claims 19 to 21, wherein the upper electrode has plural pores through which the reaction gas passes.

23. The apparatus according to any one of Claims 19 to 22, wherein the reaction space is surrounded and enclosed by an insulator.

24. The apparatus according to any one of Claims 19 to 23, wherein the transition space is surrounded and enclosed by an insulator.

25. The apparatus according to any one of Claims 19 to 24, wherein 13.56MHz or 27MHz radio-frequency power is applied to the upper electrode for exciting a plasma in the reaction space.

26. The apparatus according to any one of Claims 19 to 25, wherein the upper electrode is controlled at a temperature of 150°C or higher.

27. The apparatus according to Claim 26, wherein the upper electrode is controlled at a temperature of 200°C or higher.

28. The apparatus according to any one of Claims 19 to 27, wherein the intermediate electrode is controlled at a temperature of 100°C or higher.

29. The apparatus according to any one of Claims 19 to 28, wherein the cooling plate is controlled at a temperature of 100°C or lower.

30. The apparatus according to any one of Claims 19 to 29, wherein a gas outlet is provided between the intermediate electrode and the cooling plate to bring a cooling gas into the transition space.

31. The apparatus according to Claim 30, wherein the cooling gas is a non-reactivity gas.

32. The apparatus according to any one of Claims 19 to 31, wherein the intermediate electrode and the lower stage are electrically connected to provide the same electrical potential.

33. The apparatus according to any one of Claims 19 to 32, wherein the lower stage is controlled at a temperature of 100°C or lower.

34. A method for forming a thin film on a semiconductor substrate by plasma reaction, comprising the steps of:

    introducing a reaction gas into an upper section of a reaction chamber;
    exciting a plasma in the upper section to react the reaction gas by applying electrical power between an upper electrode and a lower stage on which a substrate is place;
    enclosing the plasma in the upper section by providing below the upper electrode an intermediate electrode having the same electrical potential as the lower stage, said intermediate electrode having plural pores through which the activated reaction gas passes;
    cooling a section under the upper section by controlling a cooling plate disposed between the intermediate electrode and the lower stage at a temperature lower than the intermediate electrode, said cooling plate having plural pores through which the cooled reaction gas passes, wherein a middle section is formed between the intermediate electrode and the cooling plate; and
    controlling the lower stage at a temperature lower than the cooling plate,

    wherein a lower section is formed between the cooling plate and the lower stage, whereby reaction products accumulate on the substrate.

35. The method according to Claim 34, wherein 13.56MHz or 27MHz radio-frequency power is applied to the upper electrode for exciting a plasma.

36. The method according to Claim 34 or Claim 35, wherein the upper electrode is controlled at a temperature of 150°C or higher.

37. The method according to Claim 36, wherein the upper electrode is controlled at a temperature of 200°C or higher.

38. The method according to any one of Claims 34 to 37, wherein the intermediate electrode is controlled at a temperature of 100°C or higher.

39. The method according to any one of Claims 34 to 38, wherein the cooling plate is controlled at a temperature of 100°C or lower.

40. The method according to any one of Claims 34 to 39, wherein a cooling gas is brought into the middle section.

41. The method according to Claim 40, wherein the cooling gas is a non-reactivity gas.

42. The method according to any one of Claims 34 to 41, wherein the lower stage is controlled at a temperature of 100°C or lower.

43. The method according to any one of Claims 34 to 42, wherein the plasma exciting step comprises repeating a first step of applying power to the upper electrode for a pre-set period of time of one msec or longer, and a second step of applying power higher than that applied in the first step for a pre-set period of time of one msec or longer.

44. The method according to any one of Claims 34 to 43, wherein the plasma exciting step comprises intermittently applying power for a pre-set period of time of one msec or longer.

45. The method according to any one of Claims 34 to 44, wherein the plasma exciting step comprising applying pulse radio-frequency power at an interval of one msec or shorter.

46. The method according to any one of Claims 34 to 45, wherein the reaction gas contains at least Si, C, H and O elements.

47. The method according to any one of Claims 34 to 46, wherein the film formed on the substrate has a dielectric constant of 2.5 or less upon subsequent thermal treatment.

48. A CVD apparatus for forming a thin film on a semiconductor substrate by plasma reaction, comprising:

   a reaction chamber;
   a reaction gas inlet for introducing a reaction gas into the reaction chamber;
   a lower stage for supporting a semiconductor substrate in the reaction chamber;
   an upper electrode for plasma excitation in the reaction chamber; and
   an electrically conductive intermediate plate with plural pores disposed between the upper electrode and the lower stage, said intermediate plate dividing the interior of the reaction chamber into an upper region and a lower region;

   wherein optionally the intermediate plate and the lower stage are electrically connected for maintaining the intermediate plate and the lower stage at the same voltage;
   and further optionally comprising a temperature controller for controlling the temperatures of the lower stage, the intermediate plate, and the upper electrode at -10°C-150°C, 50°C-200°C, and 100°C or higher, respectively

49. A CVD apparatus for forming a thin film on a semiconductor substrate by plasma reaction, comprising:

   a reaction chamber;
   a reaction gas inlet for introducing a reaction gas into the reaction chamber;
   a lower stage for supporting a semiconductor substrate in the reaction chamber, said lower stage for functioning as a lower electrode;
   an upper electrode for plasma excitation in the reaction chamber;
   an intermediate electrode with plural pores for the reaction gas to pass through, said intermediate electrode being disposed below the upper electrode, wherein a reaction space is formed between the upper electrode and the intermediate electrode; and

a cooling plate with plural pores for the reaction gas to pass through, said cooling plate being disposed between the intermediate electrode and the lower stage, said cooling plate being controllable at a temperature lower than the intermediate electrode, wherein a transition space is formed between the intermediate electrode and the cooling plate, and a plasma-free space is formed between the cooling plate and the lower stage;

wherein optionally the upper electrode has plural pores for the reaction gas to pass through;

wherein optionally the apparatus is arranged so that 13.5MHz or 27MHz radio-frequency power can be applied to the upper electrode for exciting a plasma in the reaction space;

wherein optionally the apparatus is arranged so that the upper electrode can be controlled at a temperature of 150°C or higher, preferably 200°C or higher;

wherein optionally the apparatus is arranged so that the intermediate electrode can be controlled at a temperature of 100°C or higher;

wherein optionally the apparatus is arranged so that the cooling plate can be controlled at a temperature of 100°C or lower.

wherein optionally a gas outlet is provided between the intermediate electrode and the cooling plate for bringing a cooling gas into the transition space;

wherein optionally the intermediate electrode and the lower stage are electrically connected for providing the same electrical potential; and

wherein optionally the apparatus is arranged so that the lower stage can be controlled at a temperature of 100°C or lower.

FIG. 1

FIG. 2

FIG. 3

X-ray sorce
50 kV–300mA

Slit 10Hx1.5W

Slit 10Hx0.1W

Sample

Mirror

Cu Ka

Slit 10Hx0.2W

SC

FIG. 4

EP 1 256 978 A2

FIG. 5

FIG. 6

FIG. 7